(19) Europäisches Patentamt
European Patent Office
Office européen des brevets

(11) **EP 2 399 170 B1**

(12) **EUROPÄISCHE PATENTSCHRIFT**

(45) Veröffentlichungstag und Bekanntmachung des Hinweises auf die Patenterteilung:
**23.01.2013 Patentblatt 2013/04**

(51) Int Cl.:
*G03F 7/20* (2006.01)        *G02B 27/48* (2006.01)
*H01S 3/225* (2006.01)

(21) Anmeldenummer: **10703169.2**

(22) Anmeldetag: **04.02.2010**

(86) Internationale Anmeldenummer:
**PCT/EP2010/000669**

(87) Internationale Veröffentlichungsnummer:
**WO 2010/094399 (26.08.2010 Gazette 2010/34)**

(54) **PROJEKTIONSBELICHTUNGSVERFAHREN, PROJEKTIONSBELICHTUNGSANLAGE, LASERSTRAHLUNGSQUELLE UND BANDBREITEN-EINENGUNGSMODUL FÜR EINE LASERSTRAHLUNGSQUELLE**

PROJECTION ILLUMINATION METHOD, PROJECTION ILLUMINATION SYSTEM, LASER BEAM SOURCE AND BANDWIDTH NARROWING MODULE FOR A LASER BEAM SOURCE

PROCÉDÉ D'EXPOSITION PAR PROJECTION, INSTALLATION D'EXPOSITION PAR PROJECTION, SOURCE DE RAYONNEMENT LASER ET MODULE DE RÉTRÉCISSEMENT DE LARGEUR DE BANDE POUR UNE SOURCE DE RAYONNEMENT LASER

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **17.02.2009 DE 102009010560**

(43) Veröffentlichungstag der Anmeldung:
**28.12.2011 Patentblatt 2011/52**

(73) Patentinhaber: **Carl Zeiss SMT GmbH**
**73447 Oberkochen (DE)**

(72) Erfinder: **PATRA, Michael**
**73447 Oberkochen (DE)**

(74) Vertreter: **Patentanwälte**
**Ruff, Wilhelm, Beier, Dauster & Partner**
**Kronenstrasse 30**
**70174 Stuttgart (DE)**

(56) Entgegenhaltungen:
**US-A1- 2008 225 921    US-B1- 6 898 216**

**Beschreibung**

HINTERGRUND DER ERFINDUNG

Gebiet der Erfindung

Die Erfindung betrifft ein Projektionsbelichtungsverfahren zur Belichtung eines im Bereich einer Bildfläche eines Projektionsobjektivs angeordneten, strahlungsempfindlichen Substrates mit mindestens einem Bild eines im Bereich einer Objektfläche des Projektionsobjektivs angeordneten Musters einer Maske, eine zur Durchführung des Verfahrens geeignete Projektionsbelichtungsanlage sowie eine Laserstrahlungsquelle und ein Bandbreiten-Einengungsmodul für eine Laserstrahlungsquelle.

Beschreibung des verwandten Standes der Technik

Zur Herstellung von Halbleiterbauelementen und anderen feinstrukturierten Bauteilen werden heutzutage überwiegend mikrolithografische Projektionsbelichtungsverfahren eingesetzt. Dabei werden Masken (Retikel) verwendet, die das Muster einer abzubildenden Struktur tragen, z.B. ein Linienmuster einer Schicht (layer) eines Halbleiterbauelementes. Eine Maske wird in eine Projektionsbelichtungsanlage zwischen einem Beleuchtungssystem und einem Projektionsobjektiv im Bereich der Objektfläche des Projektionsobjektivs positioniert und mit einer vom Beleuchtungssystem bereitgestellten Beleuchtungsstrahlung beleuchtet. Die durch die Maske und das Muster veränderte Strahlung läuft als Projektionsstrahlung durch das Projektionsobjektiv, welches das Muster der Maske auf das zu belichtende Substrat abbildet, das normalerweise eine strahlungsempfindliche Schicht (Fotoresist, Fotolack) trägt.

Aktuelle Projektionsbelichtungsanlagen für die hochauflösende Mikrolithographie im tiefen oder sehr tiefen Ultraviolettbereich (DUV oder VUV) verwenden als primäre Lichtquelle in der Regel einen Laser. Gebräuchlich sind insbesondere KrF-Excimerlaser mit einer Arbeitswellenlänge von ca. 248 nm oder ArF-Excimerlaser mit einer Arbeitswellenlänge von ca. 193 nm. Für 157 nm Arbeitswellenlänge wird mit $F_2$-Lasern gearbeitet, bei 126 nm sind $Ar_2$-Excimerlaser verwendbar. Die primäre Laserstrahlungsquelle emittiert einen Laserstrahl aus Laserlicht, der von dem angeschlossenen Beleuchtungssystem empfangen und zur Erzeugung einer auf die Maske gerichteten Beleuchtungsstrahlung umgeformt wird. Die spektralen Eigenschaften der Beleuchtungsstrahlung und der Projektionsstrahlung, d.h. deren von der Wellenlänge $\lambda$ bzw. der Kreisfrequenz $\omega$ abhängigen Eigenschaften, sind dabei im Wesentlichen durch die spektralen Eigenschaften der primären Laserstrahlung bestimmt.

Bei der Auslegung eines Lithografie-Prozesses werden Linienbreiten der Strukturen auf dem Retikel derart angepasst, dass nach Abbildung mit Hilfe des Projektionsobjektivs unter Verwendung einer als bekannt angenommenen Beleuchtung die gewünschten Strukturgrößen in der lichtempfindlichen Schicht belichtet werden. Dabei ist es wichtig, dass gleiche Strukturen der Maske unabhängig vom Ort auf dem Substrat gleich im Fotolack abgebildet werden. Anderenfalls können bei Halbleiterbauelementen preismindernde Geschwindigkeitsverluste oder im ungünstigsten Fall sogar Funktionsverluste auftreten. Eine kritische Größe bei der Halbleiterproduktion ist daher die durch den Prozess hervorgerufene Dickenänderung der kritischen Strukturen (CD), die auch als "Variation der kritischen Dimensionen" bzw. "CD-Variation" bezeichnet wird. Dementsprechend stellt eine gleichmäßige Breite abgebildeter identischer Strukturen über das Feld, die sogenannte CD-Uniformity, ein wesentliches Gütekriterium von Lithografieprozessen dar.

Bestimmend für die Breite einer Struktur im Fotolack ist die dort deponierte Strahlungsenergie. In einer üblichen Näherung wird angenommen, dass der Fotolack oberhalb einer bestimmten deponierten Strahlungsenergiemenge belichtet wird und darunter nicht. Der Grenzwert für die Strahlungsenergiemenge wird auch als "Lackschwelle" bezeichnet. Entscheidend ist dabei die während einer Gesamtbelichtungszeit an einer Stelle des Substrates aufintegrierte Strahlungsintensität. Die Größe der an einem bestimmten Ort im Fotoresist deponierten Strahlungsenergie hängt von einer Vielzahl von Einflußgrößen ab, unter anderem von optischen Aberrationen, insbesondere von chromatischen Aberrationen, vom Polarisationszustand der Belichtungsstrahlung sowie vom Einfluss von Streulicht und Doppelreflexen ab. Wird ein Laser als primäre Lichtquelle verwendet, so kann als weitere potentielle Ursache von CD-Variationen der Einfluss der sog. Speckles hinzukommen, die bei Verwendung von zumindest partiell kohärenter Strahlung durch Selbstinterferenz entstehen können. Maßgeblich sind hier in erster Linie die sog. zeitlich variierenden Speckles (dynamische Speckles, temporal speckles), deren Ursache zeitliche Intensitätsfluktuationen sind, die sich daraus ergeben, dass eine Lichtquelle mit einer Kohärenzzeit verwendet wird, die nicht sehr viel kürzer als die Dauer eines Laserpulses ist. Die Kohärenzzeit typischer inkohärenter Lichtquellen ist dagegen so kurz, dass zeitlich variierende Speckles dort kein Problem sind.

Bei der Auswahl geeigneter Laserstrahlungsquellen für eine Mikrolithografie-Projektionsbelichtungsanlage sind zahlreiche Einflussparameter zu beachten. Besonders bei hoch auflösenden Projektionsobjektiven mit großem Bildfeld ist die chromatische Korrektur sehr aufwändig. Ist ein Projektionsobjektiv nicht vollständig chromatisch korrigiert, so ergibt Strahlung mit verschiedenen Wellenlängen für jede Wellenlänge eine andere Fokuslage im Bildfeld des Projektionsobjektivs. Um die hierdurch entstehenden Nachteile zu vermeiden, ist man in der Regel bestrebt, sehr schmalbandige Laserstrahlungsquellen zu verwenden. Herkömmliche Excimer-Laser enthalten daher Bandbreiten-Einengungsmodule, die das natürliche Emissionsspektrum des Lasers von einigen 100pm um mehrere Zehnerpotenzen einengen, beispielsweise auf Bandbreiten von unterhalb 1 pm. Im Hinblick auf die chromatischen Aberrationen sind große Bandbreiten somit nachteilig. Dagegen sind große Bandbreiten im Hinblick auf die Entstehung von dynamischen Speckles eher günstig, da die als Speckles bezeichneten unerwünschten Interferenzerscheinungen auf die zeitliche Kohärenz des Lichtes zurückzuführen sind. Da das Licht umso weniger kohärent ist, je mehr verschiedene Wellenlängen in der Laserstrahlung enthalten sind, sind große Bandbreiten im Hinblick auf die Vermeidung von Speckles günstig.

Die Auswahl einer geeigneten Bandbreite ist also immer ein Kompromiss zwischen den Anforderungen nach geringen chromatischen Aberrationen einerseits und wenig Speckles anderseits. Die Einstellung der optimalen Bandbreite ist eine technologische Frage, die bei der Auslegung jeder Projektionsbelichtungsanlage anhand der verfügbaren Daten, beispielsweise zur chromatischen Korrektur des Projektionsobjektives, zu entscheiden ist.

In den Patentanmeldungen US 2006/0146310 A1 und US 2008/0225921 A1 werden jeweils Projektionsbelichtungsverfahren und Projektionsbelichtungsanlagen offenbart, bei denen die spektrale Intensitätsverteilung der eingesetzten Laserstrahlungsquelle eingestellt bzw. verändert werden kann. US 6,898,216 B1 offenbart eine Vorrichtung, mit den die räumliche Kohärenz vor Laserstrahlung zerstört werden kann, ohne dabei die zeitliche Kohärenz zu verändern.

ZUSAMMENFASSUNG DER ERFINDUNG

Es ist eine Aufgabe der Erfindung, ein Projektionsbelichtungsverfahren und eine zu seiner Durchführung ausgelegte Projektionsbelichtungsanlage bereitzustellen, die mit einem Laser als primärer Lichtquelle arbeiten und die dafür ausgelegt sind, den Einfluss der zeitlich variierenden Speckles auf die Bilderzeugung gegenüber herkömmlichen Systemen und Verfahren zu vermindern, ohne gleichzeitig den Einfluss chromatischer Aberrationen auf die Bilderzeugung zu vergrößern. Weiterhin soll eine zur Durchführung des Projektionsbelichtungsverfahrens geeignete Laserstrahlungsquelle sowie ein Bandbreiten-Einengungsmodul für eine Laserstrahlungsquelle bereitgestellt werden.

Diese Aufgabe wird gelöst durch ein Projektionsbelichtungsverfahren mit den Merkmalen von Anspruch 1, durch eine Projektionsbelichtungsanlage mit den Merkmalen von Anspruch 6, sowie durch eine Laserstrahlungsquelle mit den Merkmalen von Anspruch 11 und ein Bandbreiten-Einengungsmodul mit den Merkmalen von Anspruch 14. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Es wurde erkannt, dass es möglich ist, durch geeignete Einstellung der spektralen Form der Laserlinie, d.h. durch Einstellung der spektralen Intensitätsverteilung der von der primären Laserstrahlungsquelle emittierten Laserstrahlung, gezielt Einfluss auf die Balance zwischen dem Einfluss der Laserstrahlungsquelle auf die chromatischen Aberrationen und dem Einfluss der Laserstrahlungsquelle auf die Entstehung dynamischer Speckles zu nehmen.

Die Einstellung einer geeigneten spektralen Form einer Laserlinie stellt einen bisher nicht berücksichtigten Freiheitsgrad bei der Auslegung von Lithografieanlagen und -prozessen dar.

Die spektrale Intensitätsverteilung der verwendeten Laserlinie hat zwei entgegengesetzte Einflüsse auf den Lithographieprozess: Eine breite Laserlinie vergrößert die chromatischen Aberrationen, während eine schmale Laserlinie zu einer langen Kohärenzzeit und damit zu starken dynamischen Speckles führen kann. Bisher waren im Wesentlichen nur die chromatischen Aberrationen Treiber in der Laserroadmap. Daher wurden erhebliche Anstrengungen zur Entwicklung von möglichst schmalbandigen Laserstrahlungsquellen unternommen. Es wurde nun erkannt, dass auch die dynamischen Speckles erheblich reduziert werden müssen, um vorlagetreue Abbildungen mit nur vertretbar geringen CD-Variationen zu erhalten, so dass beide Einflüsse betrachtet werden müssen.

Die oben angegebene Formulierung der Erfindung beschreibt, wie durch Anpassung der spektralen Form der Laserlinie die dynamischen Speckles minimiert werden können, ohne dabei die chromatischen Aberrationen zu verschlechtern. Das kann wie folgt verstanden werden.

Sei $I(\omega)$ die spektrale Form der Laserlinie. Aus Gründen einfacherer Schreibweise wird im Folgenden die Kreisfrequenz w an Stelle der Wellenlänge $\lambda$ verwendet. Auf Grund von $d\lambda = -\dfrac{c_0}{2\pi\omega^2}\,d\omega$ mit der Lichtgeschwindigkeit $c_0$ sind für alle hier relevanten Situationen $d\lambda$ und $d\omega$ proportional (da $|d\omega| \ll w$), so dass Kreisfrequenz und Wellenlänge vollständig äquivalente Schreibweisen sind. Weiterhin wird im Folgenden davon ausgegangen, dass die Laserlinie ihr Zentrum bei Kreisfrequenz $\omega = 0$ hat, da ansonsten in den unten angegebenen Gleichungen (1) ff. an Stelle von $\omega^2$ jedes Mal $(\omega-\omega_0)^2$ geschrieben werden müsste.

Die chromatischen Aberrationen (bzw. ihre Auswirkungen für den Lithographieprozeß) sind proportional zum zweiten Moment der spektralen Verteilung, also

$$a := \frac{\int I(\omega)\omega^2 d\omega}{\int I(\omega)d\omega} \qquad (1)$$

Die dynamischen Speckles werden dagegen durch die zeitliche Autokorrelation $\mu(\Delta t)$ bestimmt. Die Kohärenzzeit $\tau$ ergibt sich mittels

$$\tau = \int \mu(\Delta t)^2 d\Delta t \qquad (2)$$

Dynamische Speckles werden schwächer, wenn die Kohärenzzeit $\tau$ klein ist, da dann innerhalb einer Laserpulses über mehr statisch unabhängige Strahlungsverteilungen gemittelt werden kann. Die Autokorrelation kann aus der normierten spektralen Intensitätsverteilung mittels Fouriertransformation (FT) berechnet werden,

$$\mu(\Delta t) \xleftarrow{\quad FT \quad} \frac{I(\omega)}{\int I(\omega)d\omega} \qquad (3)$$

Da die Fouriertransformation bekanntlich die $L_2$-Norm erhält, ist Gl. (2) äquivalent zu

$$\tau = \frac{\int I(\omega)^2 d\omega}{\left[\int I(\omega)d\omega\right]^2} \qquad (4)$$

Für den Lithographieprozeß ist es damit optimal, wenn eine spektrale Linieform $I(\omega)$ verwendet wird, bei der sowohl Gl. (1) als auch Gl. (4) möglichst klein sind. Aus Einheitenbetrachtung ergibt sich unmittelbar, dass das dimensionslose Produkt $a\tau^2$ die relevante Größe ist, d.h., eine Linienform ist umso besser für den Lithographieprozeß geeignet, je kleiner ihr Produkt $a\tau^2$ ist. Da dieses Produkt die spektrale Form der Laserlinie parametrisiert, wird das Produkt im Folgenden auch als "Linienform-parameter" $a\tau^2$ oder schlicht als "Formparameter" $a\tau^2$ bezeichnet.

Bei manchen Ausführungsformen gilt für den Linienformparameter $a\tau^2$ die Bedingung $a\tau^2 < 0.1$. Insbesondere kann die Bedingung $a\tau^2 \leq 0.09$ oder $a\tau^2 \leq 0.08$ erfüllt sein.

Zum weiteren Verständnis des Hintergrundes seien zunächst einige Grundlagen zu Linienbreiten und Profilen von Spektrallinien erwähnt. Bei der Emission elektromagnetischer Strahlung, die auf einem Übergang zwischen zwei Energieniveaus des atomaren Systems beruhen, ist die Frequenz der entsprechenden Spektrallinien nicht streng monochromatisch. Man beobachtet eine Frequenzverteilung der Intensität der emittierten Intensität um eine Mittenfrequenz. Das Frequenzintervall zwischen denjenigen beiden Frequenzen, bei denen die Intensität auf die Hälfte des bei der Mittenfrequenz vorliegenden Intensitätsmaximums angesunken ist, heißt die Halbwertsbreite (Full Width at Half Maximum, FWHM). Für die Halbwertsbreite wird in dieser Anmeldung auch der Begriff "Bandbreite" verwendet. Im Allgemeinen wird der Spektralbereich innerhalb der Halbwertsbreite als Linienkern bezeichnet, während die Bereiche beidseits außerhalb des Linienkerns als Linienflügel bezeichnet werden.

Ein angeregtes Atomelektron kann seine Anregungsenergie in Form von elektromagnetischer Strahlung wieder abgeben (spontane Emission). Bei einer spontanen Emission sendet ein Atom die Strahlung nicht streng monochromatisch aus, sondern die ausgesandte Strahlung hat eine frequenzabhängige Intensitätsverteilung. Ohne äußere Einflüsse sendet das Atom die Strahlung mit der sogenannten "natürlichen Linienform" aus, die durch ein Lorentz-Profil beschrieben wird. Die Halbwertsbreite des Lorentz-Profils ist die sogenannte natürliche Linienbreite des Emissionsprozesses.

Für den Bereich der Laserphysik ist jedoch das Lorentz-Profil nur eine grobe Näherung, die in der unmittelbaren Nähe des Zentrums der Linie, also um die Mittenfrequenz herum, gültig ist. Ein realistischer und in der Laserphysik weit verbreiterter Ansatz ist der einer modifizierten Lorentz-Kurve, die als realistische Referenz für den Vergleich unterschiedlicher Laserlinienformen dienen kann. Dies wird bei der Beschreibung bevorzugter Ausführungsbeispiele noch näher erläutert.

Eine deutliche Verringerung des Linienformparameters $a\tau^2$ im Vergleich zum Linienformparameter bei einer modifizierten Lorentz-Kurve lässt sich dann erreichen, wenn die spektrale Intensitätsverteilung $I(\omega)$ im Wesentlichen

einer Gaußkurve der Breite $\sigma$ entspricht, wobei bei der Gaußkurve $a = \sigma^2/2$ und $\tau = 1/(\sqrt{2\pi}\,\sigma)$ gilt. Eine

spektrale Intensitätsverteilung $I(\omega)$ entspricht insbesondere dann im Wesentlichen einer Gauß-Kurve, wenn sich bei einer Anpassung einer Gauß-Kurve an ein gemessenes Intensitätsprofil nur kleine Abweichungen bzw. Fehler ergeben, beispielsweise Fehler von weniger als 10% oder weniger als 8% oder weniger als 5% oder weniger als 2%.

Eine weitere Verringerung des Linienformparameters $a\tau^2$ ist dann möglich, wenn die spektrale Intensitätsverteilung $I(\omega)$ im Wesentlichen eine Parabelform hat. Eine spektrale Intensitätsverteilung $I(\omega)$ entspricht insbesondere dann im Wesentlichen einer Parabelform, wenn sich bei einer Anpassung einer Parabel an ein gemessenes Intensitätsprofil nur kleine Abweichungen bzw. Fehler ergeben, beispielsweise Fehler von weniger als 15% oder weniger als 10% oder weniger als 8% oder weniger als 5% oder weniger als 2%. Im Vergleich zu einer Gaußkurve oder einer modifizierten Lorentz-Kurve befindet sich bei einer Parabelform noch weniger Strahlungsenergie im Bereich der Linienflügel und entsprechend mehr Strahlungsenergie im Bereich des Linienkerns, was sich als günstig für die Optimierung hinsichtlich chromatischer Aberration und Speckles herausgestellt hat. Insbesondere haben die Flanken eines parabolischen Intensitätsprofils keinen Wendepunkt im Verlauf $I(\omega)$, was anschaulich deutlich macht, dass bei einem parabolischen Profil relativ viel Energie im Bereich des Linienkerns und relativ wenig Energie im Bereich der Linienflügel liegt.

Die Erfindung betrifft auch eine Projektionsbelichtungsanlage mit einer primären Laserstrahlungsquelle zur Abgabe von Laserstrahlung, für die die Bedingung $a\tau^2 \leq 0.3$ gilt.

Die Erfindung betrifft auch eine Laserstrahlungsquelle zur Abgabe von Laserstrahlung, für die die Bedingung $a\tau^2 \leq 0.3$ gilt.

Die Erfindung betrifft auch ein Bandbreiten-Einengungsmodul für eine Laserstrahlungsquelle, wobei das Bandbreiten-Einengungsmodul so ausgelegt ist, dass eine damit ausgestattete Laserstrahlungsquelle Laserstrahlung abgibt, für die die Bedingung $a\tau^2 \leq 0.3$ gilt.

Die vorstehenden und weitere Merkmale gehen außer aus den Ansprüchen auch aus der Beschreibung und aus den Zeichnungen hervor, wobei die einzelnen Merkmale jeweils für sich alleine oder zu mehreren in Form von Unterkombinationen bei einer Ausführungsform der Erfindung und auf anderen Gebieten verwirklicht sein und vorteilhafte sowie für sich schutzfähige Ausführungsformen darstellen können. Ausführungsbeispiele der Erfindung werden in den Zeichnungen dargestellt und im Folgenden näher erläutert.

KURZBESCHREIBUNG DER ZEICHNUNGEN

Fig. 1    zeigt schematisch den Aufbau einer Projektionsbelichtungsanlage für die Mikrolithographie;

Fig. 2    zeigt in 2A ein schematisches spektrales Linienprofil eines Lasers und in 2B den Einfluss einer endlichen spektralen Bandbreite einer Laserstrahlungsquelle auf die Fokusposition bei Verwendung eines nicht vollständig chromatisch korrigierten Projektionsobjektivs;

Fig. 3    zeigt ein Diagramm zu spektralen Eigenschaften der Laserstrahlung eines konventionellen Lasers;

Fig. 4    zeigt schematisch verschiedene mögliche spektrale Linienformen von Laserstrahlung; und

Fig. 5    zeigt schematisch den Aufbau eines Excimer-Lasers mit Bandbreiten-Einengungsmodul.

DETAILLIERTE BESCHREIBUNG DER BEVORZUGTEN AUSFÜHRUNGSFORMEN

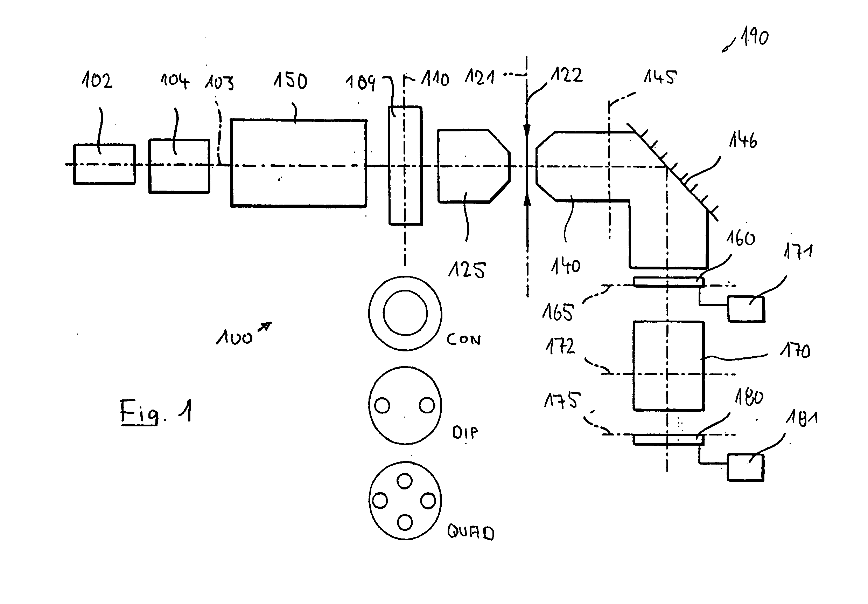

In Fig. 1 ist ein Beispiel einer Mikrolithografie-Projektionsbelichtungsanlage 100 gezeigt, die bei der Herstellung von Halbleiterbauelementen und anderen feinstrukturierten Bauteilen einsetzbar ist und zur Erzielung von Auflösungen bis zu Bruchteilen von Mikrometern mit Licht bzw. elektromagnetischer Strahlung aus dem tiefen Ultraviolettbereich (VUV) arbeitet. Als primäre Lichtquelle 102 dient ein ArF-Excimer-Laser mit einer Arbeitswellenlänge von ca. 193 nm, dessen linear polarisierter Laserstrahl koaxial zur optischen Achse 103 des Beleuchtungssystems 190 in das Beleuchtungssystem eingekoppelt wird. Andere UV-Laserstrahlungsquellen, beispielsweise $F_2$-Laser mit 157 nm Arbeitswellenlänge oder KrF-Excimer-Laser mit 248 nm Arbeitswellenlänge sind ebenfalls möglich.

Das polarisierte Licht der Lichtquelle 102 tritt zunächst in einen Strahlaufweiter 104 ein, der beispielsweise zur Kohärenzreduktion und Vergrößerung des Strahlquerschnitts dient. Der aufgeweitete Laserstrahl tritt in eine Pupillenformungseinheit 150 ein, die eine Vielzahl optischer Komponenten und Gruppen enthält und dazu ausgelegt ist, in einer nachfolgenden Pupillenformungsfläche 110 des Beleuchtungssystems 190 eine definierte, örtliche (zweidimensionale) Beleuchtungsintensitätsverteilung zu erzeugen, die manchmal auch als sekundäre Lichtquelle oder als "Beleuchtungspupille" bezeichnet wird. Die Pupillenformungsfläche 110 ist eine Pupillenfläche des Beleuchtungssystems.

Die Pupillenformungseinheit 150 ist variabel einstellbar, so dass in Abhängigkeit von der Ansteuerung der Pupillenformungseinheit unterschiedliche lokale Beleuchtungsintensitätsverteilungen (d.h. unterschiedlich strukturierte sekundäre Lichtquellen) eingestellt werden können. In Fig. 1 sind verschiedene Ausleuchtungen der kreisförmigen Beleuchtungspupille beispielhaft schematisch gezeigt, nämlich ein konventionelles Setting CON mit zentriertem, kreisförmigem Beleuchtungsfleck, eine Dipolbeleuchtung DIP oder eine Quadrupolbeleuchtung QUAD.

In unmittelbarer Nähe der Pupillenformungsfläche 110 ist ein optisches Rasterelement 109 angeordnet. Eine dahinter angeordnete Einkoppeloptik 125 überträgt das Licht auf eine Zwischenfeldebene 121, in der ein Retikel/Masking-System (REMA) 122 angeordnet ist, welches als verstellbare Feldblende dient. Das optische Rasterelement 109, das auch als felddefinierendes Element (FDE) bezeichnet wird, hat eine zweidimensionale Anordnung diffraktiver oder refraktiver optischer Elemente und formt die eintretende Strahlung so, dass sie nach Durchtritt durch die nachfolgende Einkoppeloptik 125 im Bereich der Feldebene 121 ein rechteckförmiges Beleuchtungsfeld ausleuchtet. Die Strahlung wird außerdem durch Überlagerung von Teilstrahlbündeln homogenisiert, so dass das FDE als Feldformungs- und Homogenisierungselement dient.

Das nachfolgende Abbildungsobjektiv 140 (auch REMA-Objektiv genannt) bildet die Zwischenfeldebene 121 mit der Feldblende 122 auf das Retikel 160 (Maske, Lithografievorlage) in einem Maßstab ab, der z.B. zwischen 2:1 und 1:5 liegen kann und bei der Ausführungsform etwa bei 1:1 liegt.

Diejenigen optischen Komponenten, die das Licht des Lasers 102 empfangen und aus dem Licht Beleuchtungsstrahlung formen, die auf das Retikel 160 gerichtet ist, gehören zum Beleuchtungssystem 190 der Projektionsbelichtungsanlage.

Hinter dem Beleuchtungssystem ist eine Einrichtung 171 zum Halten und Manipulieren des Retikels 160 so angeordnet, dass das am Retikel angeordnete Muster in der Objektebene 165 des Projektionsobjektives 170 liegt und in dieser Ebene zum Scannerbetrieb in einer Scan-Richtung (y-Richtung) senkrecht zur optischen Achse 103 (z-Richtung) mit Hilfe eines Scanantriebs bewegbar ist.

Hinter der Retikelebene 165 folgt das Projektionsobjektiv 170, das als Reduktionsobjektiv wirkt und ein Bild des an der Maske 160 angeordneten Musters in reduziertem Maßstab, beispielsweise im Maßstab 1:4 oder 1:5, auf einen mit einer Fotoresistschicht bzw. Fotolackschicht belegten Wafer 180 abbildet, dessen lichtempfindliche Oberfläche in der Bildebene 175 des Projektionsobjektivs 170 liegt. Es sind refraktive, katadioptrische oder katoptrische Projektionsobjektive möglich. Andere Reduktionsmaßstäbe, beispielsweise stärkere Verkleinerungen bis 1:20 oder 1:200, sind möglich.

Das zu belichtende Substrat, bei dem es sich im Beispielsfall um einen Halbleiterwafer 180 handelt, wird durch eine Einrichtung 181 gehalten, die einen Scannerantrieb umfasst, um den Wafer synchron mit dem Retikel 160 senkrecht zur optischen Achse zu bewegen. Je nach Auslegung des Projektionsobjektivs 170 (z.B. refraktiv katadioptrisch oder katoptrisch, ohne Zwischenbild oder mit Zwischenbild, gefaltet oder ungefaltet) können diese Bewegungen zueinander parallel oder gegenparallel erfolgen. Die Einrichtung 181, die auch als "Waferstage" bezeichnet wird, sowie die Einrichtung 171, die auch als "Retikelstage" bezeichnet wird, sind Bestandteil einer Scannereinrichtung, die über eine Scan-Steuereinrichtung gesteuert wird.

Die Pupillenformungsfläche 110 liegt an oder nahe einer Position, die optisch konjugiert zur nächsten nachfolgenden Pupillenfläche 145 sowie zur bildseitigen Pupillenfläche 172 des Projektionsobjektivs 170 ist. Somit wird die räumliche (örtliche) Lichtverteilung in der Pupille 172 des Projektionsobjektivs durch die räumliche Lichtverteilung (Ortsverteilung) in der Pupillenformungsfläche 110 des Beleuchtungssystems bestimmt. Zwischen den Pupillenflächen 110, 145, 172 liegen jeweils Feldflächen im optischen Strahlengang, die Fourier-transformierte Flächen zu den jeweiligen Pupillenflächen sind. Dies bedeutet insbesondere, dass eine definierte Ortsverteilung von Beleuchtungsintensität in der Pupillenformungsfläche 110 eine bestimmte Winkelverteilung der Beleuchtungsstrahlung im Bereich der nachfolgenden Feldfläche 121 ergibt, die wiederum einer bestimmten Winkelverteilung der auf das Retikel 160 fallenden Beleuchtungsstrahlung entspricht.

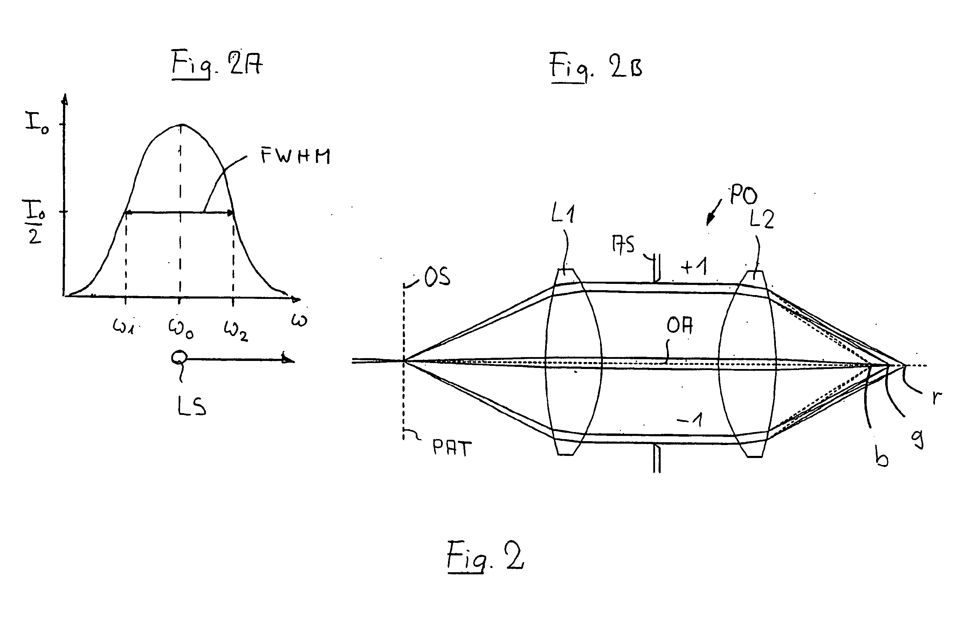

Die Laserstrahlungsquelle 102 gibt Laserstrahlung mit einem bestimmten, von der Wellenlängen $\lambda$ bzw. von der Kreisfrequenz w abhängigen spektralen Intensitätsprofil $I(\omega)$ ab. Anhand von Fig. 2 werden schematisch die Auswirkungen der Verwendung einer Lichtquelle mit endlicher Bandbreite auf die Bildqualität bei Verwendung eines nicht vollständig chromatisch korrigierten Projektionsobjektivs erläutert.

Hierzu zeigt Fig. 2A schematisch das spektrale Intensitätsprofil $I(\omega)$ der Laserstrahlungsquelle LS. Das Maxi-

mum der Intensität, $I_0$, liegt bei der Mittenfrequenz $\omega_0$. Das Frequenzintervall $\Delta\omega = |\omega_2 - \omega_1|$ zwischen den beiden Frequenzen $\omega_1$ und $\omega_2$, bei denen die Intensität auf die Hälfte des Maximalwertes abgesunken ist, heißt die volle Halbwertsbreite (FWHM, Full Width at Half Maximum). Es ist ersichtlich, dass zur Laserlinie unterschiedliche Wellenlängen gehören, die mit unterschiedlicher Intensität zum Gesamtsignal beitragen. Der Spektralbereich innerhalb der Halbwertsbreite wird auch als Linienkern, die Bereiche außerhalb werden als Linienflügel bezeichnet.

Figur 2B zeigt schematisch ein Projektionsobjektiv PO mit zwei koaxial zur optischen Achse OA angeordneten Linsenelementen L1, L2, die das Abbildungssystem repräsentieren, welches das Muster PAT, welches sich in der Objektfläche OS des Projektionsobjektivs befindet, in den Bereich der zur Objektfläche optisch konjugierten Bildfläche IS abbilden. Eine Aperturblende AS definiert die effektive bildseitige numerische Apertur NA der Abbildung und ist in der Nähe einer Pupillenfläche des Objektivs angeordnet. Das Muster PAT der Maske ist schematisch als Beugungsgitter dargestellt, welches das vom Beleuchtungssystem bereitgestellte Beleuchtungslicht in eine 0. Beugungsordnung entlang der optischen Achse sowie eine -1. Beugungsordnung und eine +1. Beugungsordnung am äußeren Rand des durch die Aperturblende begrenzten Strahlengangs beugt.

Die breitbandige Laserstrahlungsquelle LS emittiert Strahlung unterschiedlicher Wellenlängen mit unterschiedlichen Intensitäten, wobei in Anlehnung an die Farben des Lichts im sichtbaren Spektralbereich die mittlere Wellenlänge mit "g" für "grün" bezeichnet wird, die längste Wellenlänge mit "r" für "rot" und die kürzeste Wellenlänge mit "b" für "blau". Es versteht sich, dass die Verhältnisse für Wellenlängen aus dem tiefen ultravioletten Bereich von unterhalb 260 nm entsprechend zu übertragen sind. Bei einem System mit chromatischer Unterkorrektur liegt dann die Fokusebene der relativ kürzesten Wellenlänge (b) näher am optischen System, während die relativ längeren Wellenlängen (g) und (r) sukzessive weiter entfernt vom Projektionsobjektiv fokussiert werden. Das zu belichtende Substrat, beispielsweise ein Halbleiterwafer, kann jedoch nur in Bezug auf eine der Wellenlängen exakt in den Fokusbereich gebracht werden, die Fokuslagen der anderen Wellenlängen liegen dann außerhalb der zu belichtenden Oberfläche.

Die Fokuslage ändert sich in erster Näherung linear mit der Wellenlänge (bei einem chromatisch korrigierten Objektiv wäre dieser Effekt nur quadratisch mit der Wellenlänge). Die Variation der kritischen Dimensionen ($\Delta$CD) steigt dementsprechend quadratisch mit der Wellenlängenänderung. Daraus ergibt sich, dass die chromatischen Aberrationen, bzw. ihre Auswirkung für den Lithografieprozess, proportional zum zweiten Moment der spektralen Verteilung sind, was für die Zwecke dieser Anmeldung durch den Aberrationsparameter $a$ parametrisiert wird, für den gilt :

$$a := \frac{\int I(\omega)\omega^2 d\omega}{\int I(\omega) d\omega} \qquad (1)$$

Neben der hier ausführlicher erläuterten Wellenlängenabhängigkeit der Fokuslage gehört zu den chromatischen Aberrationen auch die Wellenlängenabhängigkeit des Vergrößerungsmassstabes. Auch dieser Effekt ist durch den Aberrationsparameter $a$ erfasst.

Die zweite hier betrachtete Einflussgröße auf den Lithografieprozess sind die dynamischen Speckles. Speckles entstehen durch unkontrollierte bzw. unkontrollierbare Interferenz zwischen verschiedenen Teilen des Laserstrahls. Durch die Interferenz kommt es an manchen Orten zur Auslöschung des Lichts, was einem Kontrast von 100% entspricht. Die exakte Form des Specklemusters hängt von den Phasenbeziehungen der verschiedenen Teile des Laserstrahls ab, die sich im Laufe der Zeit ändern. Diese zeitlichen Intensitätsfluktuationen werden in der Fachliteratur als "temporal Speckles" oder "dynamische Speckles" bezeichnet. Berücksichtigt man, dass die einzige Möglichkeit zur Kontrastreduktion in diesen Fällen in der Überlagerung vieler verschiedener Specklesmuster während der Dauer eines Laserpulses liegt, so führt dies zu der Frage, wie schnell sich die Specklesmuster ändern. Die Anzahl unabhängiger Specklemuster ergibt sich aus der Dauer des Laserpulses, geteilt durch die Phasenkorrelationszeit der Laserstrahlung. Die Korrelationszeit wiederum ergibt sich aus den unterschiedlichen Frequenzen des Lichts in der Laserstrahlung, hängt also mit der Linienform des abgestrahlten Intensitätsspektrums zusammen. Für die Zwecke dieser Anmeldung ergibt sich diese Korrelationszeit bzw. Kohärenzzeit $\tau$ aus folgender Gleichung:

$$\tau = \frac{\int I(\omega)^2 d\omega}{\left[\int I(\omega) d\omega\right]^2} \qquad (4)$$

Die obige Gleichung zeigt, dass es einen Zusammenhang zwischen der zeitlichen Kohärenz einer Lichtquelle und ihrer spektralen Bandbreite gibt. Wenn beide Größen effektiv definiert werden, so ergibt sich, dass die Größen zueinander umgekehrt proportional sind. Eine weitere vertiefte Analyse zeigt, dass auch die spektrale Form der von der Lichtquelle abgegebenen Strahlung in diese Relation eingeht.

Der Aberrationsparameter $a$ ist proportional zum Quadrat der Bandbreite, während die Kohärenzzeit $\tau$ proportional zum Kehrwert der Bandbreite ist. Eine wichtige Folgerung aus dieser Erkenntnis ist, dass das Produkt $a\tau^2$ unabhängig von der Bandbreite ist. Dies bedeutet wiederum, dass die Bandbreite der Laserstrahlungsquelle für einen Lithografieprozess aufgrund technologischer Parameter gewählt werden kann und dass die über den Linienformparameter $a\tau^2$ parametrisierte spektrale Linienform als freier Parameter verbleibt, um eine Optimierung zwischen dem Einfluss der Strahlungsquelle auf die chromatischen Aberrationen und dem Einfluss der Strahlungsquelle auf die Erzeugung dynamischer Speckles zu erzielen.

Im Folgenden wird nun die Größe des Linienformparameters für verschiedene Laserlinienformen näher erläutert.

In Lehrbüchern wird oft dargestellt, dass die spektrale Form einer Laserlinie ein Lorentzprofil sei:

$$I(\omega) = \frac{1}{1 + \left| \frac{\omega}{2\Delta} \right|^2} \qquad (6)$$

Dies ist jedoch nur eine grobe Näherung, die in der unmittelbaren Nähe des Zentrums der Linie gültig ist. Ein sinnvollerer und in der Laserphysik weit verbreiteter Ansatz ist der einer modifizierten Lorentzkurve,

$$I(\omega) = \frac{1}{1 + \left| \frac{\omega}{2\Delta} \right|^\nu}, \quad \nu > 2 \qquad (7)$$

Damit die chromatische Aberration $a$ nicht divergiert, damit optische Lithographie also überhaupt möglich ist, muss $\nu > 3$ sein. Für die chromatische Aberrationen ergibt sich dann

$$a = 4\Delta^2 \frac{\sin(\pi/\nu)}{\sin(3\pi/\nu)} \qquad (8)$$

und für die Kohärenzzeit

$$\tau = \frac{[\nu - 1]\sin(\pi/\nu)}{4\pi\Delta} \qquad (9)$$

Der Wert für $\nu$ kann aus dem FWHM (Full Width at Half Maximum) und dem E95-Wert (95% der Energie sind innerhalb dieses Frequenzbereichs) berechnet werden. Diese Werte sind somit durch spektroskopische Messtechnik zugänglich.

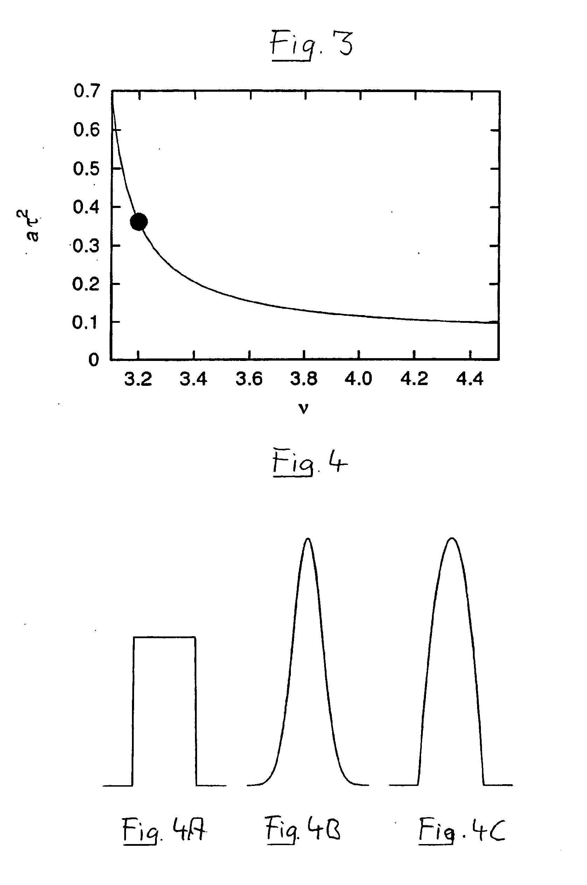

Aus Messdaten für einen XLA-360-Laser als Referenzlaser ergab sich z.B. $\nu = 3.2$. Wird der Linienformparameter $a\tau^2$ als Funktion von $\nu$ aufgetragen, so ergibt sich die in Fig. 3 gezeigte Kurve. Der Punkt markiert den Wert $\nu = 3.2$ des kommerziell erhältlichen, "realen" Lasers, der einem Wert des Linienformparameters von ca. $a\tau^2 = 0.38$ entspricht. Der Limit von $a\tau^2$ für $\nu \to \infty$ ist $a\tau^2 = 1/12$ (bzw. $a\tau^2 \approx 0.083$), so dass jenseits von $\nu = 4.5$ nur noch marginale Verbesserungen erzielbar sind.

Selbst wenn man sich auf modifizierte Lorentzfunktionen als denkbare spektrale Linienformen beschränkt, so kann $a\tau^2$ also um mehr als einen Faktor 3 gegenüber dem Referenzlaser verbessert werden.

Erlaubt man andere spektrale Linienformen, insbesondere eine Parabelform, so ist sogar eine größere Verbesserung möglich, was im Folgenden noch erläutert wird.

Für verschiedene kommerziell erhältliche Laser existieren verschiedene Angaben für v, und zwar im Bereich v=3.2 bis v=3.75. Es wird angenommen, dass die Unterschiede nur zum Teil auf die Laser, zum anderen Teil aber auf die Messung und die Auswertung zurückzuführen sind. Es bleibt somit zu bewerten, wie groß das Verbesserungspotential für die einzelnen Laser tatsächlich ist. Eine direkte Integration eines gemessenen Laserprofils für den XLA-360 ergab $a\tau^2$ = 0.26, während der Umweg über eine rechnerische Anpassung (fit) von v etwa $a\tau^2$ = 0.36 ergab (siehe Fig. 3).

Diese Zahlen müssen mit dem Grenzwert $1/12 \approx 0.083$ für die modifizierte Lorentzfunktion und $9/125 \approx 0.072$ für eine Parabelform verglichen werden.

Um die Vorteile der Erfindung etwas anschaulicher zu machen, seien hier anhand von Fig. 4 einfache Beispiele gezeigt:

Die in Fig. 4A gezeigte Linienform $I(\omega)$ sei ein (spektraler) Flattop der Breite $\Delta$. Dann ergibt sich aus Gl. (1) $a = \Delta^2/12$, und aus Gl. (4) $\tau = 1/\Delta$. Das Produkt bzw. der Linienformparameter ist damit $a\tau^2 = 1/12$ (= 0.083).

Wird stattdessen für $I(\omega)$ eine Gaußkurve (als Funktion der Frequenz) mit Breite $\sigma$ angenommen (Fig. 4B), so ergibt sich aus Gl. (1) $a = \sigma^2/2$, und aus Gl. (4) $\tau = 1/[\sqrt{(2\pi)}\sigma]$. Das Produkt bzw. der Linienformparameter $a\tau^2$ ist damit $a\tau^2 = 1/(4\pi) \approx 0.080$

Das Produkt $a\tau^2$ ist also für eine Gaußkurve etwas kleiner als für einen Flattop. Damit kann für eine Gaußkurve bei konstanten chromatischen Aberrationen eine etwas kürzere Kohärenzlänge und damit weniger Speckle erreicht werden. Alternativ können bei gleichem Speckle die chromatischen Aberrationen verringert werden, wenn statt eines Flattops eine Gaußkurve verwendet wird. In anderen Worten: Eine Laserlinie mit Gaußform ist besser als ein Flattop für die optische Lithographie geeignet, wenn es darum geht, den Einfluss der zeitlich variierenden Speckles auf die Bilderzeugung gegenüber herkömmlichen Systemen und Verfahren zu vermindern, ohne gleichzeitig den Einfluss chromatischer Aberrationen auf die Bilderzeugung zu vergrößern.

Die Bedingung, dass das Produkt $a\tau^2$ gemäß Gl. (1) und Gl. (4) minimiert werden soll, ergibt ein mathematisch wohldefiniertes Problem. Die folgende optimierte Linienform wurde mittels einer Monte-Carlo-Simulation bestimmt. Die Laserlinie dieser optimierten Variante hat die Form einer abgeschnittenen Parabel (siehe auch Fig. 4 C).

$$I(\omega) = \begin{cases} c\left[1 - \left(\omega/\Delta\right)^2\right] & |\omega| \leq \Delta \\ 0 & |\omega| \geq \Delta \end{cases} \qquad (10)$$

Für diese Kurvenform ist $a = \Delta 2/5$ und $\tau = 3/(5\Delta)$, und als Produkt $a\tau 2$ ergibt sich $a\tau^2$ = 9/125 entsprechend $a\tau^2 \approx 0.072$. Die Produkte (Linienformparameter) $a\tau^2$ für die verschiedenen Kurvenformen sind also

Flattop: $\qquad a\tau^2$ = 1/12 = 0.083
Gauß-Kurve: $\quad a\tau^2$ = 1/(4π) = 0.080
Parabelform: $\quad a\tau^2$ = 9/125 = 0.072

Die Parabelform ist also in der Tat besser als das Gauß-Profil oder das Flattop-Profil.

Die Beispiele zeigen, dass es für die hier erläuterte Problematik wichtig ist, was im Bereich der Flanken eines Intensitätsprofils passiert. Wenn z.B. 1 % der Gesamtenergie innerhalb der Flanken verschoben wird, so hat dieses eine um Größenordnungen stärkeren Einfluss als wenn 1 % der Gesamtenergie innerhalb des Linienkerns verschoben wird. Daher sollte eine Laserlinienform einen möglichst kleinen Flankenbeitrag haben, wobei der Begriff "Flanke" hier im Wesentlichen für den Übergangsbereich zwischen Linienkern und Linienflügel steht. In diesem Sinne hat eine Gaußkurve breitere Flanken als die Parabel - die Flanken gehen bei einer Gaußkurve theoretisch bis ins Unendliche, während diese bei einer Parabel nur endlich weit gehen. Werden die Flanken dagegen wie bei einem Flattop vollständig abgeschnitten, so wird ein Teil des Kerns jetzt zur Flanke, weil alles, was außen liegt, ja eine Art Flanke ist. Bei einem Flattop wird somit ein Bereich zur Flanke, der eine sehr hohe Intensität hat. Die Parabel ist daher vor dem Hintergrund der zugrundeliegenden Problematik ein sehr guter Kompromiss.

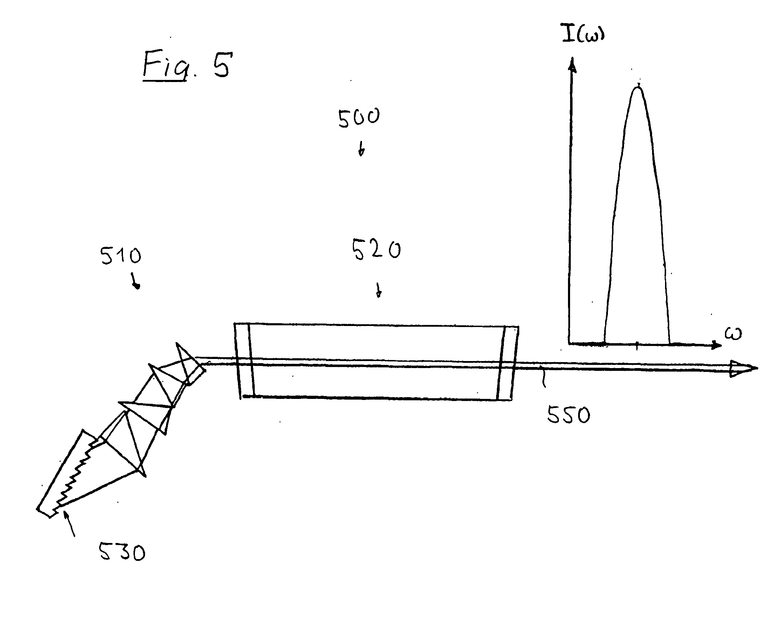

Anhand von Fig. 5 wird an einem Beispiel eine Möglichkeit zur Beeinflussung der spektralen Linienform bei einem Excimer-Laser gegeben. Excimer-Laser sind zurzeit die für die Mikrolithographie im DUV - und VUV-Bereich hauptsächlich verwendeten primären Lichtquellen. Ein Excimer-Laser oszilliert in vielen verschiedenen räumlichen Moden und hat im Vergleich zu anderen Lasertypen einen niedrigen Grad der räumlichen Kohärenz. Außerdem wird ein relativ breites Spektrum abgegeben, was geringe zeitliche Kohärenz bedeutet. Hinzu kommen wesentlich höhere Abstrahlleistungen als bei herkömmlichen Nicht-Laserquellen im UV-Bereich. Die natürliche Bandbreite eines Excimer-Lasers kann im Bereich mehrerer 100pm liegen und muss daher erheblich eingeengt werden, um eine für die Mikrolithographie taugliche schmale Bandbreite zu liefern. Daher sind Excimer-Laser für die Mikrolithographie mit sogenannten Bandbreiten-Einengungsmodulen ausgestattet. Bei der Laserstrahlungsquelle von Fig. 5 bildet das Bandbreiten-Einengungsmodul 510 den rückwärtigen Resonatorabschluss des Lasers und hat die Funktion, durch wellenlängenselektive Reflektion die Bandbreite der emittierten Laserstrahlung zu reduzieren. An das rückseitige Auskopplungsfenster einer Verstärkungs- bzw. Gasentladungskammer 520 schließt sich eine Strahlaufweitungseinheit 512 mit vier hintereinander liegenden, geeignet angeordneten Prismen bis an. Der aufgeweitete Laserstrahl trifft auf ein Echelle-Gitter 530 in Littrowkonfiguration, so dass der einfallende aufgeweitete Laserstrahl in sich selbst reflektiert wird. Dieser Grundaufbau ist an sich bekannt. Das spektrale Linienprofil des Lasers ist nun im Wesentlichen durch die spektrale Reflektivität des Echelle-Gitters 530 bestimmt. Durch Blazen des Gitters oder auf eine andere Weise kann das Höhenprofil des Gitters bei der Herstellung derart festgelegt werden, dass sich die gewünschte spektrale Intensitätsverteilung im ausgehenden Laserstrahl 550 ergibt.

Im Ausführungsbeispiel ist das Höhenprofil des Echelle-Gitters 530 derart ausgelegt, dass die vom Laser 500 emittierte Laserstrahlung 550 eine spektrale Linienform nach Art einer nach unten geöffneten Parabel hat, die sich im Wesentlichen durch die in Gleichung (10) angegebene Beschreibung parametrisieren lässt.

Bei der Herstellung des Reflektionsgitters 530 für das Bandbreiten-Einengungsmodul wird die gewünschte spektrale Linienform des emittierten Laserstrahls vorgegeben. Durch Rückrechnung wird daraus das zu dieser Linienform führende Höhenprofil des Reflektionsgitters ermittelt. Anschließend wird das Reflektionsgitter durch an sich bekannte Herstellungsverfahren hergestellt, beispielweise durch Blazen.

Es wurde gezeigt, wie durch geeignete Einstellung der spektralen Linienform der Lithographieprozess verbessert werden kann. Ein Faktor 4 für den Linienformparameter $a\tau^2$ bedeutet - bei gleichen chromatischen Aberrationen - eine Kohärenzzeit, die um den Faktor 2 kürzer ist, und damit eine Speckleredukion um einen Faktor $\sqrt{2} \approx 1.5$. Dieselbe Speckleredukion könnte auch mittels Pulslängenverdoppelung durch einen Pulsstretcher erreicht werden, was allerdings die Transmission um ungefähr 20% verringern würde. Eine Erhöhung der Bandbreite zwecks Verringerung der Kohärenzzeit würde dagegen kostspielige Maßnahmen zur besseren Farbkorrektur im Objektiv bedingen. Die vorgeschlagene Einstellung der spektralen Linienform des Lasers ist dagegen eine technische Maßnahme, die keine relevanten negativen Folgen hat.

**Patentansprüche**

1. Projektionsbelichtungsverfahren zur Belichtung eines im Bereich einer Bildfläche eines Projektionsobjektivs angeordneten, strahlungsempfindlichen Substrats mit mindestens einem Bild eines im Bereich einer Objektfläche des Projektionsobjektivs angeordneten Musters einer Maske mit:

Erzeugen von Laserstrahlung mit einer von der Kreisfrequenz $\omega$ abhängigen spektralen Intensitätsverteilung I($\omega$), wobei die Laserstrahlung weiterhin charakterisierbar ist durch einen Aberrationsparameter $a$ gemäß:

$$a := \frac{\int I(\omega)\omega^2 d\omega}{\int I(\omega) d\omega}$$

und eine Kohärenzzeit $\tau$: gemäß

$$\tau = \frac{\int I(\omega)^2 d\omega}{\left[\int I(\omega) d\omega\right]^2}$$

Einführen der Laserstrahlung in ein Beleuchtungssystem zur Erzeugung einer auf die Maske gerichteten Beleuchtungsstrahlung;

Abbilden des Musters auf das Substrat mit Hilfe eines Projektionsobjektivs;
wobei die spektrale Intensitätsverteilung derart eingestellt wird, dass für einen Linienformparameter $a\tau^2$ die Bedingung $a\tau^2 \leq 0.3$ gilt

2. Projektionsbelichtungsverfahren nach Anspruch 1, worin die spektrale Intensitätsverteilung derart eingestellt wird, dass für den Linienformparameter $a\tau^2$ die Bedingung $a\tau^2 \leq 0.1$ gilt

3. Projektionsbelichtungsverfahren nach Anspruch 1 oder 2, worin die spektralen Intensitätsverteilung I($\omega$) einer

Gaußkurve der Halbwertsbreite $\sigma$ entspricht, wobei bei der Gaußkurve $a = \sigma^2/2$ und $\tau = 1/(\sqrt{2\pi}\ \sigma)$ gilt.

4. Projektionsbelichtungsverfahren nach Anspruch 1 oder 2, worin die spektralen Intensitätsverteilung I($\omega$) eine Parabelform hat.

5. Projektionsbelichtungsverfahren nach Anspruch 1 oder 2, worin ein Maximum der spektralen Intensitätsverteilung im Ultraviolettbereich bei einer Wellenlänge von weniger als 260 nm liegt, insbesondere bei 193 nm.

6. Projektionsbelichtungsanlage zur Belichtung eines im Bereich einer Bildfläche eines Projektionsobjektivs angeordneten, strahlungsempfindlichen Substrats mit mindestens einem Bild eines im Bereich einer Objektfläche des Projektionsobjektivs angeordneten Musters einer Maske mit:

einer primären Laserstrahlungsquelle zur Abgabe von Laserstrahlung;
einem Beleuchtungssystem zum Empfang der Laserstrahlung und zur Erzeugung einer auf die Maske gerichteten Beleuchtungsstrahlung;
einem Projektionsobjektiv zur Erzeugung eines Bildes des Musters im Bereich der Bildfläche des Projektionsobjektivs;
wobei die Laserstrahlungsquelle zur Erzeugung von Laserstrahlung mit einer von der Kreisfrequenz w abhängigen spektralen Intensitätsverteilung I($\omega$) ausgelegt ist, wobei die Laserstrahlung charakterisierbar ist durch einen Aberrationsparameter $a$ gemäß:

$$a := \frac{\int I(\omega)\omega^2 d\omega}{\int I(\omega)d\omega}$$

und eine Kohärenzzeit $\tau$: gemäß

$$\tau = \frac{\int I(\omega)^2 d\omega}{\left[\int I(\omega)d\omega\right]^2},$$

wobei die spektrale Intensitätsverteilung derart eingestellt ist, dass für einen Linienformparameter $a\tau^2$ die Bedingung $a\tau^2 \leq 0.3$ gilt.

7. Projektionsbelichtungsanlage nach Anspruch 6, wobei die spektrale Intensitätsverteilung derart eingestellt ist, dass für den Linienformparameter $a\tau^2$ die Bedingung $a\tau^2 \leq 0.1$ gilt.

8. Projektionsbelichtungsanlage nach Anspruch 6 oder 7, worin die spektralen Intensitätsverteilung I($\omega$) einer

Gaußkurve der Halbwertsbreite $\sigma$ entspricht, wobei bei der Gaußkurve $a = \sigma^2/2$ und $\tau = 1/(\sqrt{2\pi}\ \sigma)$ gilt.

9. Projektionsbelichtungsanlage nach Anspruch 6 oder 7, worin die spektralen Intensitätsverteilung I($\omega$) eine Parabel-

form hat.

10. Projektionsbelichtungsanlage nach einem der Ansprüche 6 bis 9, worin ein Maximum der spektralen Intensitätsverteilung im tiefen Ultraviolettbereich bei einer Wellenlänge von weniger als 260 nm liegt, insbesondere bei 193 nm.

11. Laserstrahlungsquelle zur Erzeugung von Laserstrahlung mit einer von der Kreisfrequenz w abhängigen spektralen Intensitätsverteilung I($\omega$) zum Einsatz in einer Projektionsbelichtungsanlage gemäß einem der Ansprüche 1 bis 10, wobei die Laserstrahlung charakterisierbar ist durch einen Aberrationsparameter $a$ gemäß:

$$a := \frac{\int I(\omega)\omega^2 d\omega}{\int I(\omega)d\omega}$$

und eine Kohärenzzeit $\tau$: gemäß

$$\tau = \frac{\int I(\omega)^2 d\omega}{\left[\int I(\omega)d\omega\right]^2},$$

wobei die spektrale Intensitätsverteilung derart eingestellt ist, dass für einen Linienformparameter $a\tau^2$ die Bedingung $a\tau^2 \leq 0.3$ gilt.

12. Laserstrahlungsquelle nach Anspruch 11, **gekennzeichnet durch** die Merkmale des kennzeichnenden Teils von mindestens einem der Ansprüche 7 bis 10.

13. Laserstrahlungsquelle nach Anspruch 11 oder 12, **gekennzeichnet durch** ein Bandbreiten-Einengungsmodul mit einem Reflexionsgitter zur wellenlängenselektiven Reflexion von Laserstrahlung eines Resonators der Laserstrahlungsquelle derart, dass eine spektrale Intensitätsverteilung der Laserstrahlung im Wesentlichen **durch** eine spektrale Reflektivität des Reflexionsgitters bestimmt ist, wobei ein Höhenprofil des Reflexionsgitters derart festgelegt ist, dass sich die spektrale Intensitätsverteilung I($\omega$) mit dem Linienformparameter $a\tau^2$ ergibt, für den die Bedingung $a\tau^2 \leq 0.3$ gilt.

14. Bandbreiten-Einengungsmodul für eine Laserstrahlungsquelle gemäß einem der Ansprüche 11 bis 13, mit einem Reflexionsgitter zur wellenlängenselektiven Reflexion von Laserstrahlung eines Resonators der Laserstrahlungsquelle derart, dass eine spektrale Intensitätsverteilung der Laserstrahlung im Wesentlichen durch eine spektrale Reflektivität des Reflexionsgitters bestimmt ist, **dadurch gekennzeichnet, dass** ein Höhenprofil des Reflexionsgitters derart festgelegt ist, dass sich für die Laserstrahlung eine von der Kreisfrequenz w abhängige spektralen Intensitätsverteilung I($\omega$) ergibt, wobei die Laserstrahlung charakterisierbar ist durch einen Aberrationsparameter $a$ gemäß:

$$a := \frac{\int I(\omega)\omega^2 d\omega}{\int I(\omega)d\omega}$$

und eine Kohärenzzeit $\tau$: gemäß

$$\tau = \frac{\int I(\omega)^2 d\omega}{\left[\int I(\omega)d\omega\right]^2},$$

wobei für einen Linienformparameter $a\tau^2$ die Bedingung $a\tau^2 \leq 0.3$ gilt.

15. Bandbreiten-Einengungsmodul nach Anspruch 14, worin das Höhenprofil des Reflexionsgitters derart ausgelegt ist, dass die spektrale Intensitätsverteilung $I(\omega)$ im Wesentlichen einer Gaußkurve der Halbwertsbreite $\sigma$ entspricht, wobei bei der Gaußkurve $a = \sigma^2/2$ und $\tau = 1/(\sqrt{2\pi}\,\sigma)$ gilt, oder worin das Höhenprofil des Reflexionsgitters derart ausgelegt ist, dass die spektrale Intensitätsverteilung $I(\omega)$ im Wesentlichen eine Parabelform hat.

## Claims

1. Projection exposure method for the exposure of a radiation-sensitive substrate arranged in the region of an image surface of a projection objective with at least one image of a pattern of a mask arranged in the region of an object surface of the projection objective, comprising:

   generating laser radiation having a spectral intensity distribution $I(\omega)$ dependent on the angular frequency $\omega$, wherein the laser radiation can furthermore be **characterized by** an aberration parameter $\alpha$ in accordance with:

   $$a := \frac{\int I(\omega)\omega^2 d\omega}{\int I(\omega)d\omega}$$

   and a coherence time $\tau$ in accordance with:

   $$\tau = \frac{\int I(\omega)^2 d\omega}{\left[\int I(\omega)d\omega\right]^2}$$

   introducing the laser radiation into an illumination system for generating an illumination radiation directed onto the mask;
   imaging the pattern onto the substrate with the aid of a projection objective;
   wherein the spectral intensity distribution is set in such a way that, for a line shape parameter $\alpha\tau^2$, the condition $\alpha\tau^2 \leq 0.3$ holds true.

2. Projection exposure method according to Claim 1, wherein the spectral intensity distribution is set in such a way that, for the line shape parameter $\alpha\tau^2$, the condition $\alpha\tau^2 \leq 0.1$ holds true.

3. Projection exposure method according to Claim 1 or 2, wherein the spectral intensity distribution $I(\omega)$ corresponds to a Gaussian curve of the full width at half maximum $\sigma$, wherein $\alpha = \sigma^2/2$ and $\tau = 1/\left(\sqrt{2\pi}\,\sigma\right)$ hold true for the Gaussian curve.

4. Projection exposure method according to Claim 1 or 2, wherein the spectral intensity distribution $I(\omega)$ has a parabolic shape.

5. Projection exposure method according to Claim 1 or 2, wherein a maximum of the spectral intensity distribution lies in the ultraviolet range at a wavelength of less than 260 nm, in particular at 193 nm.

6. Projection exposure apparatus for the exposure of a radiation-sensitive substrate arranged in the region of an image surface of a projection objective with at least one image of a pattern of a mask arranged in the region of an object surface of the projection objective, comprising:

a primary laser radiation source for emitting laser radiation;
an illumination system for receiving the laser radiation and for generating an illumination radiation directed onto the mask;
a projection objective for generating an image of the pattern in the region of the image surface of the projection objective;
wherein the laser radiation source is designed for generating laser radiation having a spectral intensity distribution I(w) dependent on the angular frequency ω,
wherein the laser radiation can be **characterized by** an aberration parameter α in accordance with:

$$a := \frac{\int I(\omega)\omega^2 d\omega}{\int I(\omega)d\omega}$$

and a coherence time τ in accordance with:

$$\tau = \frac{\int I(\omega)^2 d\omega}{\left[\int I(\omega)d\omega\right]^2}$$

wherein the spectral intensity distribution is set in such a way that, for a line shape parameter $\alpha\tau^2$, the condition $\alpha\tau^2 \leq 0.3$ holds true.

7. Projection exposure apparatus according to Claim 6, wherein the spectral intensity distribution is set in such a way that, for the line shape parameter $\alpha\tau^2$, the condition $\alpha\tau^2 \leq 0.1$ holds true.

8. Projection exposure apparatus according to Claim 6 or 7, wherein the spectral intensity distribution I(ω) corresponds to a Gaussian curve of the full width at half maximum σ, wherein $\alpha = \sigma^2/2$ and $\tau = 1 / \left(\sqrt{2\pi}\ \sigma\right)$ hold true for the Gaussian curve.

9. Projection exposure apparatus according to Claim 6 or 7, wherein the spectral intensity distribution I(ω) has a parabolic shape.

10. Projection exposure apparatus according to any of Claims 6 to 9, wherein a maximum of the spectral intensity distribution lies in the deep ultraviolet range at a wavelength of less than 260 nm, in particular at 193 nm.

11. Laser radiation source for generating laser radiation having a spectral intensity distribution I(w) dependent on the angular frequency w for use in a projection exposure apparatus according to any of Claims 1 to 10, wherein the laser radiation can be **characterized by** an aberration parameter α in accordance with:

$$a := \frac{\int I(\omega)\omega^2 d\omega}{\int I(\omega)d\omega}$$

and a coherence time τ in accordance with:

$$\tau = \frac{\int I(\omega)^2 \, d\omega}{\left[\int I(\omega) d\omega\right]^2}$$

wherein the spectral intensity distribution is set in such a way that, for a line shape parameter $\alpha\tau^2$, the condition $\alpha\tau^2 \leq 0.3$ holds true.

**12.** Laser radiation source according to Claim 11, **characterized by** the features of the characterizing part of at least one of Claims 7 to 10.

**13.** Laser radiation source according to Claim 11 or 12, **characterized by** a bandwidth narrowing module comprising a reflection grating for the wavelength-selective reflection of laser radiation of a resonator of the laser radiation source in such a way that a spectral intensity distribution of the laser radiation is substantially determined by a spectral reflectivity of the reflection grating, wherein a height profile of the reflection grating is defined in such a way as to result in the spectral intensity distribution I(w) with the line shape parameter $\alpha\tau^2$, for which the condition $\alpha\tau^2 \leq 0.3$ holds true.

**14.** Bandwidth narrowing module for a laser radiation source according to any of Claims 11 to 13, comprising a reflection grating for the wavelength-selective reflection of laser radiation of a resonator of the laser radiation source in such a way that a spectral intensity distribution of the laser radiation is substantially determined by a spectral reflectivity of the reflection grating, **characterized in that** a height profile of the reflection grating is defined in such a way that a spectral intensity distribution I($\omega$) dependent on the angular frequency $\omega$ results for the laser radiation, wherein the laser radiation can be **characterized by** an aberration parameter $\alpha$ in accordance with:

$$a := \frac{\int I(\omega)\omega^2 d\omega}{\int I(\omega) d\omega}$$

and a coherence time $\tau$ in accordance with:

$$\tau = \frac{\int I(\omega)^2 \, d\omega}{\left[\int I(\omega) d\omega\right]^2}$$

wherein, for a line shape parameter $\alpha\tau^2$, the condition $\alpha\tau^2 \leq 0.3$ holds true.

**15.** Bandwidth narrowing module according to Claim 14, wherein the height profile of the reflection grating is designed in such a way that the spectral intensity distribution I($\omega$) substantially corresponds to a Gaussian curve of the full width at half maximum $\sigma$, wherein $\alpha=\sigma^2/2$ and $\tau = 1 \big/ \left(\sqrt{2\pi}\ \ \sigma\right)$ hold true in the case of the Gaussian curve, or wherein the height profile of the reflection grating is designed in such a way that the spectral intensity distribution I($\omega$) substantially has a parabolic shape.

**Revendications**

**1.** Procédé d'exposition par projection pour l'exposition d'un substrat sensible au rayonnement disposé dans le champ d'une surface d'image d'un objectif de projection avec au moins une image d'un motif d'un masque disposé dans le champ d'une surface objet de l'objectif de projection avec :

production de rayonnement laser avec une répartition spectrale de l'intensité I(ω) fonction de la pulsation ω, le rayonnement laser pouvant en outre être **caractérisé par** un paramètre d'aberration $\alpha$ selon :

$$\alpha = \frac{\int I(\omega)\omega^2 d\omega}{\int I(\omega)d\omega}$$

et une durée de cohérence τ selon

$$\tau = \frac{\int I(\omega)^2 d\omega}{\left[\int I(\omega)d\omega\right]^2}$$

introduction du rayonnement laser dans un système d'exposition pour produire un rayonnement d'exposition dirigé sur le masque ;
reproduction du motif sur le substrat à l'aide d'un objectif de projection ;
la répartition spectrale de l'intensité étant réglée de telle sorte que pour un paramètre de forme linéaire $\alpha\tau^2$, la condition $\alpha\tau^2 \leq 0{,}3$ s'applique.

2. Procédé d'exposition par projection selon la revendication 1, dans lequel la répartition spectrale de l'intensité est réglée de telle sorte que pour le paramètre de forme linéaire $\alpha\tau^2$, la condition $\alpha\tau^2 \leq 0{,}1$ s'applique.

3. Procédé d'exposition par projection selon la revendication 1 ou 2, dans lequel la répartition spectrale de l'intensité I(ω) correspond à une courbe de Gauss de demi largeur σ, $\alpha = \sigma^2/2$ et $\tau = 1/\left(\sqrt{2\pi}\ \ \sigma\right)$ s'appliquant à la courbe de Gauss.

4. Procédé d'exposition par projection selon la revendication 1 ou 2, dans lequel la répartition spectrale de l'intensité I(ω) a une forme parabolique.

5. Procédé d'exposition par projection selon la revendication 1 ou 2, dans lequel un maximum de la répartition spectrale de l'intensité se situe dans le domaine de l'ultraviolet avec une longueur d'ondes de moins de 260 nm, notamment à 193 nm.

6. Installation d'exposition par projection pour l'exposition d'un substrat sensible au rayonnement disposé dans le champ d'une surface d'image d'un objectif de projection avec au moins une image d'un motif d'un masque disposé dans le champ d'une surface objet de l'objectif de projection avec :

une source primaire de rayonnement laser pour la fourniture de rayonnement laser ;
un système d'exposition pour la réception du rayonnement laser et pour la production d'un rayonnement d'exposition dirigé sur le masque ;
un objectif de projection pour la production d'une image du motif dans le champ de la surface de l'image de l'objectif de projection ;
la source de rayonnement laser étant conçue pour la production de rayonnement laser avec une répartition spectrale de l'intensité I(ω) fonction de la pulsation ω, le rayonnement laser pouvant être **caractérisé par** un paramètre d'aberration $\alpha$ selon :

$$\alpha = \frac{\int I(\omega)\omega^2 d\omega}{\int I(\omega)d\omega}$$

et une durée de cohérence τ selon

$$\tau = \frac{\int I(\omega)^2 d\omega}{\left[\int I(\omega)d\omega\right]^2},$$

la répartition spectrale de l'intensité étant réglée de telle sorte que pour un paramètre de forme linéaire $\alpha\tau^2$, la condition $\alpha\tau^2 \leq 0,3$ s'applique.

7.  Installation d'exposition par projection selon la revendication 6, dans laquelle la répartition spectrale de l'intensité est réglée de telle sorte que pour le paramètre de forme linéaire $\alpha\tau^2$, la condition $\alpha\tau^2 \leq 0,1$ s'applique.

8.  Installation d'exposition par projection selon la revendication 6 ou 7, dans laquelle la répartition spectrale de l'intensité $I(\omega)$ correspond à une courbe de Gauss de demi largeur $\sigma$, $\alpha = \sigma^2/2$ et $\tau = 1 / \left(\sqrt{2\pi} \ \sigma\right)$ s'appliquant à la courbe de Gauss.

9.  Installation d'exposition par projection selon la revendication 6 ou 7, dans laquelle la répartition spectrale de l'intensité $I(\omega)$ a une forme parabolique.

10. Installation d'exposition par projection selon une des revendications 6 à 9, dans laquelle un maximum de la répartition spectrale de l'intensité se situe dans le domaine de l'ultraviolet profond avec une longueur d'ondes de moins de 260 nm, notamment à 193 nm.

11. Source de rayonnement laser pour la production de rayonnement laser avec une répartition spectrale de l'intensité $I(\omega)$ fonction de la pulsation $\omega$, pour l'utilisation dans une installation d'exposition par projection selon une des revendications 1 à 10, le rayonnement laser pouvant être **caractérisé par** un paramètre d'aberration $\alpha$ selon :

$$\alpha = \frac{\int I(\omega)\omega^2 d\omega}{\int I(\omega)d\omega}$$

et une durée de cohérence $\tau$ selon

$$\tau = \frac{\int I(\omega)^2 d\omega}{\left[\int I(\omega)d\omega\right]^2},$$

la répartition spectrale de l'intensité étant réglée de telle sorte que pour un paramètre de forme linéaire $\alpha\tau^2$, la condition $\alpha\tau^2 \leq 0,3$ s'applique.

12. Source de rayonnement laser selon la revendication 11, **caractérisée par** les particularités de la partie caractéristique d'au moins une des revendications 7 à 10.

13. Source de rayonnement laser selon la revendication 11 ou 12, **caractérisée par** un module de rétrécissement de la largeur de bande avec une grille de réflexion pour la réflexion sélective en longueur d'ondes du rayonnement laser d'un résonateur de la source de rayonnement laser de telle sorte qu'une répartition spectrale de l'intensité du rayonnement laser est définie pour l'essentiel par une réflectivité spectrale de la grille de réflexion, un profil de hauteur de la grille de réflexion étant fixé de telle sorte que la répartition spectrale de l'intensité $I(\omega)$ est donnée par le paramètre de forme linéaire $\alpha\tau^2$, pour lequel la condition $\alpha\tau^2 \leq 0,3$ s'applique.

14. Module de rétrécissement de la largeur de bande pour une source de rayonnement laser selon une des revendications 11 à 13, avec une grille de réflexion pour la réflexion sélective en longueur d'ondes du rayonnement laser d'un résonateur de la source de rayonnement laser de telle sorte qu'une répartition spectrale de l'intensité du rayonnement laser est définie pour l'essentiel par une réflectivité spectrale de la grille de réflexion, **caractérisé en ce qu'**un profil de hauteur de la grille de réflexion est fixé de telle sorte que pour le rayonnement laser, il découle une répartition spectrale de l'intensité I(ω) fonction de la pulsation ω, le rayonnement laser pouvant être **caractérisé par** un paramètre d'aberration $\alpha$ selon :

$$\alpha = \frac{\int I(\omega)\omega^2 d\omega}{\int I(\omega)d\omega}$$

et une durée de cohérence τ selon

$$\tau = \frac{\int I(\omega)^2 d\omega}{\left[\int I(\omega)d\omega\right]^2},$$

la condition $\alpha\tau^2 \leq 0{,}3$ s'appliquant pour un paramètre de forme linéaire $\alpha\tau^2$.

15. Module de rétrécissement de la largeur de bande selon la revendication 14, dans lequel le profil de hauteur de la grille de réflexion est conçu de telle sorte que la répartition spectrale de l'intensité I(ω) correspond pour l'essentiel à une courbe de Gauss de demi largeur σ, $\alpha = \sigma^2/2$ et $\tau = 1/\left(\sqrt{2\pi}\ \sigma\right)$ s'appliquant à la courbe de Gauss, ou dans lequel le profil de hauteur de la grille de réflexion est conçu de telle sorte que la répartition spectrale de l'intensité I(ω) correspond pour l'essentiel à une forme parabolique.

Fig. 1

Fig. 2A

Fig. 2B

Fig. 2

EP 2 399 170 B1

## Fig. 3

## Fig. 4

Fig. 4A          Fig. 4B          Fig. 4C

EP 2 399 170 B1

Fig. 5

500

510

520

$I(\omega)$

$\omega$

550

530

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20060146310 A1
- US 20080225921 A1
- US 6898216 B1